# EUROPEAN PATENT APPLICATION

(11) **EP 3 121 615 A2**
(43) Date of publication of application: **25.01.2017**
(21) Application number: 16171506.5
(22) Date of filing: 21.10.2004
(51) Int. Cl.: G01R 33/54

(54) **DIAGNOSTIC IMAGING SYSTEM WITH USER INTERFACE**

(30) Priority: 24.10.2003 EP 03103951
(62) Divisional of application: 04770304.6
(71) Applicant: Koninklijke Philips N.V., 5656 AE Eindhoven (NL)
(72) Inventor: BENSCHOP, Frank, J., M., 5656 AE Eindhoven (NL); SPRINGORUM, Rudolf, T., 5656 AE Eindhoven (NL); VAN DEN BRINK, Johan, S., 5656 AE Eindhoven (NL); BUURMAN, Johannes, 5656 AE Eindhoven (NL); TUITHOF, Hans, H., 5656 AE Eindhoven (NL); HOOGEVEEN, Romhild, M., 5656 AE Eindhoven (NL)
(74) Representative: Cohen, Julius Simon

(57) **Abstract**

A diagnostic imaging system (1), in particular a magnetic resonance imaging system. The diagnostic imaging system comprises control system (2) to control the execution of operational items by the diagnostic imaging system. A user interface (3) is coupled to the control system, the user interface including a scheduler module which forms an ordered selection of operational items. The operational items are executed on the basis of the ordered selection. The ordered selection concerns the order, timing and conditions to be fulfilled to execute the operational items. Notably, in a magnetic resonance imaging system the actual acquisition concerns the execution of acquisition pulse sequences to receive magnetic resonance signals which is carried out for the planned geometry.

## Description

### FIELD OF THE INVENTION

The invention relates to a diagnostic imaging modality, in particular a magnetic resonance imaging system, with a user interface.

Such a diagnostic imaging modality is known from the US-patent application US2002/0085026. The international application WO02/39899 mentions handling of the imaging process based on workflow templates which help the operator to compose an overall processing schedule. The US-patent US 6 493 571 concerns an MR angiography apparatus which allows to user to select an appropriate template and enter parameters into the template.

### BACKGROUND OF THE INVENTION

The diagnostic imaging modality known from the US-patent application US2002/0085026 has a medical system architecture wherein the devices for processing examination images are fashioned as an RIS client for the exchange of text messages as well as for displaying an RIS client window. The devices for processing examination images are connected via a network connection to an RIS server. The RIS client is made available desktop-integrated on the operator console, for example as an RIS-window of the diagnostic imaging modality. Hence the RIS-function can be operated from the same keyboard without need for the operator to change location. Further, the RIS-function can operate as a workflow driver which sends request data in the form of a DICOM work list entry to the diagnostic imaging modality.

### SUMMARY OF THE INVENTION

An object of the invention is to provide a diagnostic imaging system which has a user interface which supports improving the efficiency of the workflow.

This object is achieved according to the invention by a diagnostic imaging system, in particular a magnetic resonance imaging system, comprising:
a control system to control the execution of operational items by the diagnostic imaging system and
a user interface coupled to the control system, the user interface including a scheduler module which forms an ordered selection of operational items.

The diagnostic imaging modality of the invention is provided with a user interface that supports to a large extent the automated operation of the diagnostic imaging modality. To this end the scheduler module generates or constructs the ordered selection of operational items. The control system controls execution of operational items by the diagnostic imaging modality. The operational items are executed on the basis of the ordered selection. The ordered selection of operational items includes the order of succession and the timing according to which the operational items are to be executed. Also any relations between operational items are included in the ordered selection, such as the completion of one operational items being a condition to be fulfilled before a next operational item can be executed, or the precise way an operational item is to be executed depending on the result of a previous operational item. Notably, the scheduler module generates ordered selection of various types of operational items. These various types relate to different functions of the diagnostic imaging system, such as acquisition of data, processing of the acquired data including reconstruction of images from the acquired data and image processing functions, viewing functions, such as setting the lay out of the display, patient handling functions and handling of patient information, user interface functions such as issuing instructions, indicating progress or providing additional information. Such additional information for example includes also additional information or instructions to the operator in the event manual intervention by the operator is needed.

The invention is particularly advantageous when employed in a magnetic resonance imaging system. The operational items are for example various image acquisition sequences, planning of a *region of interest,* such one or several cross sectional slices. Operation items may also concern displacing the patient to be examined (as in moving bed imaging), administering a contrast agent (viz. in contrast enhanced MR-angiography).

The invention is also particularly advantageously employed in diagnostic imaging systems such as computed tomography imaging systems, x-ray examination systems and ultrasound diagnostic imaging systems.

These and other aspects of the invention will be further elaborated with reference to the embodiments defined in the dependent Claims.

In a preferred embodiment of the diagnostic imaging system of the invention, the scheduler module is set up to form the ordered selection of the operational items on the basis of their actual parameter settings. These parameter settings of an operational item specify the type of operational item, the activities it involves and the way they are performed. These parameters may be of the type of scan parameters that define acquisition sequences, notably pulse sequences for acquiring magnetic resonance signals, and the ordering of several of such acquisition sequences. Another type of parameters concern viewing functions, such as e.g. the screen lay out used by the display. Notably the screen lay out setting may be made dependent on the type of examination. A further type of parameters pertain to image processing such as selection of windowing and zooming or application of a maximum or minimum intensity projection (MIP or mIP). Yet another type of parameters relate to various aspects of patient handling, such as positioning and infusion of contrast agent. For infusion of contrast agent, relevant parameters are for example the dose and the infusion rate of the contrast agent as well as the optimum timing of the infusion. Also data concerning patient information may be included. Examples of operational items and their parameter settings are the type of acquisition sequences and the details and order of RF-pulses and temporary magnetic gradient fields being applied, also the degree of undersampling is a relevant parameter setting when a parallel imaging technique such as SENSE or SMASH is employed in magnetic resonance imaging. Especially, when parallel imaging is employed, another relevant operational item is the selection and the positioning of a set of RF excitation and/or receiver coils, notably in the form of surface coils. Another operational item concerns the electromagnetic matching of the set of additional (surface) coils with other coils that are employed, such as a body coil. A further example of operational items is the type of RF-coils, notably surface coils used and the way they are positioned. A next example concerns the positioning of the patient to be examined; this may concerns the details of how the patient is positioned for the acquisition of diagnostic images such as magnetic resonance images at a single position, but various examinations involve acquisition of magnetic resonance images at successive positioning of the patient to be examined. Magnetic resonance images may be acquired while the patient to be examined is continuously moved. A further example of an operational item is the administering of contrast agent and which acquisition sequence is to be employed to acquire magnetic resonance signals upon the administering of the contrast agent. Further, the parameters of the operational items may be pre-set, but may also be set on the basis of a survey scan of the patient to be examined. According to the invention, the scheduler module arranges the operational items in their proper ordered selection based on the actual parameter settings. The scheduler module may carry out this arranging as much as possible autonomously, on the basis of the actual parameter settings. Then scheduler module may also support an editing mode in which the operator can edit the ordered selection taking into account specific requirements of the examination to be carried out. Hence, the operator needs less effort the make sure the selection of operational items is correct in view of the actual parameter settings involved. Moreover, the ordered selections are easily and accurately reproduced. Also the ordered selection well supports flexibility in that variations of existing ordered selections are easily implemented.

In a further preferred embodiment, the control system activates the diagnostic imaging system according to operational items in an execution list. The scheduler releases the operational items to the execution list in their proper order given by the ordered selection and also takes account of conditions to be fulfilled for the operational items to be carried out by the diagnostic imaging system. Such conditions for example involve the geometric planning being performed of the *region of interest* and/or the *field-of-view* for an acquisition sequence. Another example is that before the acquisition for contrast enhanced imaging it is required that the contrast agent has been administered and for example has arrived at the *region of interest* at issue. Yet another example of a condition to be fulfilled is whether the appropriate RF-coils have been correctly put in place. According to this aspect of the invention the operator is less or not at all involved in checking if particular conditions are fulfilled for a particular operational item, such as the execution of an acquisition sequence. More generally, such conditions may also involve the successful completion of earlier operational items in the ordered selection, so that the operator does not need to monitor the diagnostic imaging system for operational items to have been completed and there is no need to manually interfere to activate the next operational items or repeat an unsuccessful operational item. Also, the invention allows the operator to focus more on the results obtained, such as the magnetic resonance image reconstructed from the acquired data, rather than having to focus on the data acquisition process. Accordingly, work flow is made more efficient so that patient throughput is improved and the operator can give more attention to the patient to be examined. This improved efficiency may also be extended to the administrative and financial handling of the diagnostic imaging procedure.

In an attractive embodiment the operational items include next to actual acquisition sequences also the geometry planning for the acquisition sequences. The geometry planning in particular concerns the setting of the size and location of the *field-of-view* for an acquisition sequence. The actual acquisition concerns the execution of acquisition pulse sequences to receive magnetic resonance signals which is carried out for the planned geometry. Several acquisition sequences may share the same geometry planning. According to one aspect of the invention the sharing of geometries in included in the ordered selection, for example by adding the shared geometry planning as an attribute to the acquisition sequence. Acquisition sequences having the same geometry planning are released together to the execution list once the geometry planning for at least one of these acquisition sequences is performed. Hence, the operator needs only to carry out the geometry planning once, and the other acquisition sequences having the same geometry are initiated autonomously for exactly the same planned geometry.

Preferably, the diagnostic imaging system is provided with a memory which is accessible by the scheduler module to store scan schedules. These scan schedules represent the ordered selection of operational items. Because the scan schedules are available in the memory, these are easily retrieved, notably when they proved successful in previous diagnostic imaging procedures. Hence, the operator does not need to re-program earlier scan schedules. For example, exactly the same scan schedule can be applied repeatedly to the same patient at successive examinations. Advantageously, the memory is provided in the form of a database with a browser, so that earlier scan schedules are easily found. Preferably, the database is functionally accessible by a data network so that the scan schedules can comfortably be shared by different users. For example, scan schedules can be exchanged as e-mail attachments or can be made available to several users through a server that is accessible by these users. For example the user interface is operative to communicate the ordered selection of operational items, or just a reference to such operational items, over a RIS (radiology information system). Hence, the ordered selection of operational items can be edited remote from the diagnostic imaging modality. When the patient is checked in for imaging, the required ordered selection of operational items is simply loaded into the execution list on the basis of the patient information received upon check-in.

In a further preferred embodiment the scheduler module is arranged to issue instructions prompted by the operational items. These instruction may be issued in the form of synthesized speech or may be displayed on the user interface. Notably, the instructions relate to manual actions the operator needs to perform, such as starting to infuse contrast agent or to apply a surface RF-coil at its correct position. Because the operator is instructed to take action at the appropriate moments when the diagnostic system under control of the control system on the basis of the ordered selection of operational items provided by the scheduler module has completed the operational items up to where interference by the operator is needed, there is less need for the operator to monitor progress of the execution of the operational items until the operator's interference is needed.

The invention also relates to a magnetic resonance imaging system with a patient support that can be moved among various imaging positions. For example, the patient support is a patient table that is moveable to respective imaging positions, also called 'stations', where different parts of the patient's anatomy can be imaged. According to a further aspect of the invention at individual stations several image acquisition sequences are carried out. Notably, all image acquisition sequences that the operator has specified are carried out at a current station and the patient support is moved to the next station when all image acquisition sequences for the current station have been completed. Hence, the displacements of the patient support with the patient remains limited to a small number. The respective image acquisitions and displacements are preferably entered as an ordered selection of operational items, viz. the image acquisition sequences and the displacements in their proper order. Further, the ordered selection of operational items may also include settings of the viewing function to display the several magnetic resonance images that are reconstructed from the respective image acquisitions. The magnetic resonance images notably may concern different types of image contrast. These respective magnetic resonance images are displayed in separate viewports of the display. Generally, these several magnetic resonance images are displayed simultaneously, but they may be also be displayed successively. Hence, although this forms a somewhat complex selection of operational items to be carried out, there is not much involvement of the operator required. Moreover, the image acquisition sequences at the same stations have the same geometry planning. Hence, the ordered selection includes the sharing of the respective geometry planning for individual stations. No additional manual geometry planning is needed once a geometry planning is done at the separate stations. Moreover, the geometry planning is exactly equal for different image acquisition sequences for the same station and is accurately equally valid as the patient is hardly displaced while at the same station. Because the geometry planning is available for the image acquisition at each of the stations and for each of the respective image acquisitions per station, the ordered selection is also includes instructions to form composite images from magnetic resonance images at successive stations and for corresponding image acquisition methods. These composite images show all image information acquired at successive stations in a single image; that is for example a composite image of most of the patients entire body is shown in the composite image. Several composite image can be made for respective image acquisition methods that for example pertain to different types of image contrast. According to one aspect of the invention, at individual stations respective image acquisitions are done at some selected acquisition order. This acquisition order is then included in the ordered selection. Also attributed to these acquired images are the geometric information representing relative geometric locations of these acquired images. Such geometric information is easily derived from the geometric planning of the respective image acquisitions sequences. On the basis of this geometric information the composite images are formed by joining the acquired images of the respective stations in their proper geometric order or relationship that may be different from the acquisition order. These operational items concerning the formation of the composite images are for example included in the ordered selection and may be released into the execution list to allow the composite images to be formed either 'on the fly' or subsequent to completion of the image acquisition sequences without further intervention of the operator. These and other aspects of the invention will be elucidated with reference to the embodiments described hereinafter and with reference to the accompanying drawing wherein

### BRIEF DESCRIPTION OF THE DRAWINGS

Figure 1 shows a schematic representation of a diagnostic imaging modality according to the invention,
Figure 2 shows an example of a user interface of the diagnostic imaging modality of the invention,
Figure 3 shows a detail of the user interface shown in Figure 2 and
Figure 4 shows an example of a user interface of the diagnostic image modality of the invention in which several imaging sequences at individual imaging positions are carried out.

### DETAILED DESCRIPTION OF THE EMBODIMENTS

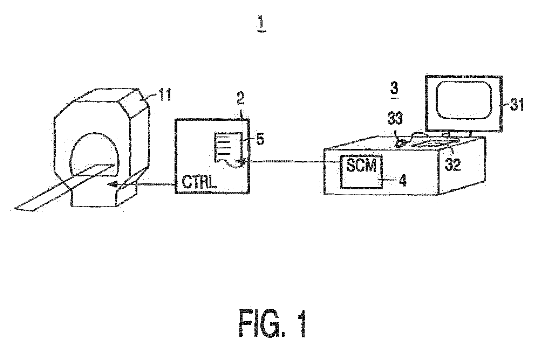

Figure 1 shows a schematic representation of a diagnostic imaging modality 1 according to the invention. The diagnostic imaging modality includes an imaging system 11, such as a magnetic resonance imaging system, a computed tomography system, an ultrasound imaging system or an x-ray imaging system. The embodiments described in more detail with respect to the drawings will concern a diagnostic imaging modality of the invention which includes a magnetic resonance imaging system 11 which acquires magnetic resonance signals from a patient to be examined and reconstructs magnetic resonance images of the patient to be examined. The magnetic resonance imaging system includes a control system 2 which controls the operation of the magnetic resonance imaging system in that operational items are executed, such as acquisition sequences including RF-pulses and magnetic gradient field pulses are applied, magnetic resonance signals received and the magnetic resonance images reconstructed. The control system operates the magnetic resonance imaging system on the basis of a sequence of the operational items that are included in the execution list 5. The execution list 5 is filled with operational items by the scheduler module 4 that is part of the user interface 3 of the magnetic resonance imaging system. The user interface further comprises a display 31, a keyboard 32 and a mouse 33 which enables the operator to communicate via the user interface with the diagnostic imaging system. The user interface allows the operator to select ordered selection of operational items from the memory of the scheduler module. In practice the ordered selection of operational items are termed 'exam cards'. These exam cards list the activities in their proper order and including the relevant relationships between the activities to be carried out in the course of the diagnostic imaging of the patient to be examined.

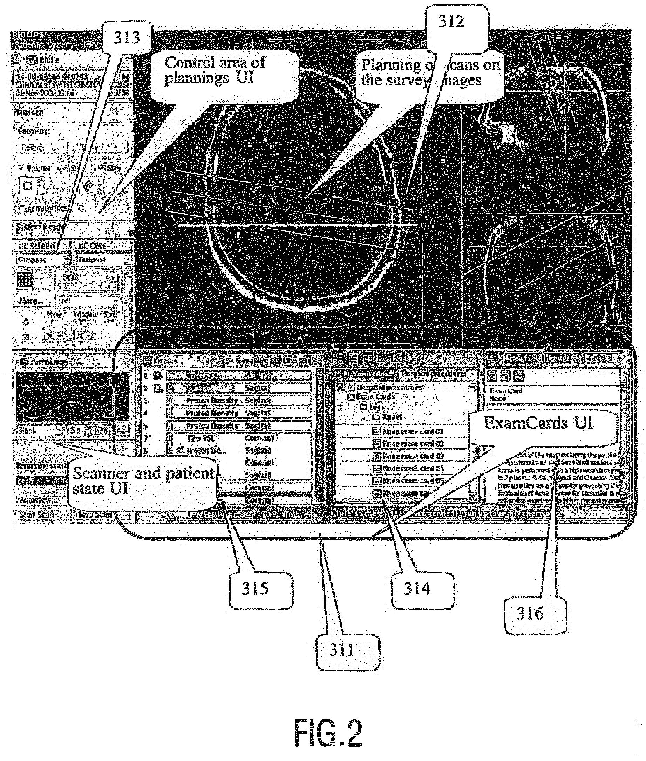

Figure 2 shows an example of a user interface of the diagnostic imaging modality of the invention. In particular, Figure 2 shows the view given on the display 31 of the user interface where the display is set up so as to have one of the viewports 311 showing the exam cards. In the actual situation shown in figure 2, some of the display's viewports 312 show survey images of the patient to be examined on which a *region of interest* is being planned. Another viewport 313 concerns a control area which provides the operator which in the present stage of the MR-imaging, tools to control the plan the *region of interest,* i.e. to set and manipulate the stacks of slices needed to image the *region of interest.*

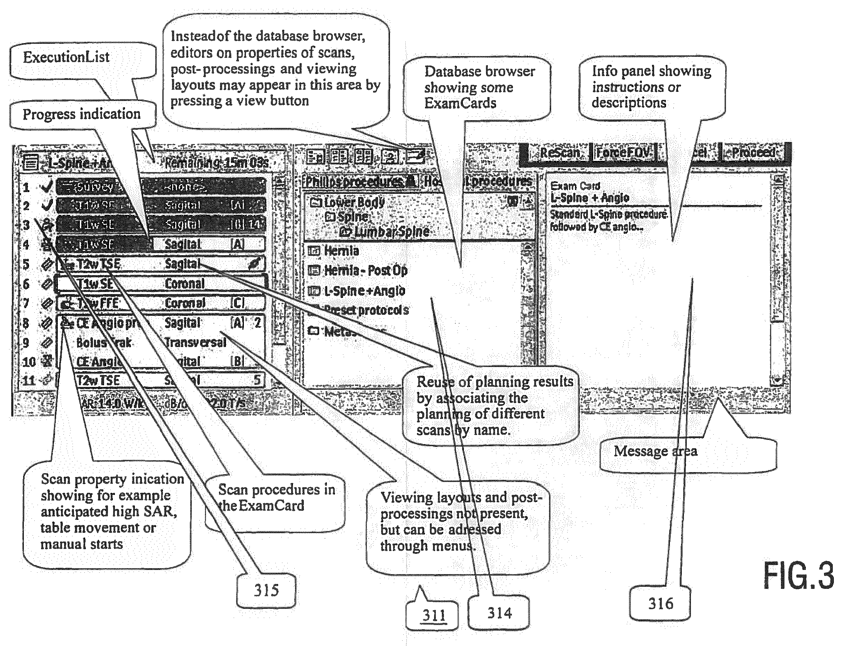

The viewport 311 concerning the exam cards makes available a collection of exam cards from the memory; these are shown in the list 314. The various operational items of the selected exam card that is active are shown in a representation 315 of the execution list 5. The exam cards may be selected e.g. by mouse clicks on selected entries in the list 314. More details of the viewport concerning exam cards are shown in Figure 3.

Figure 3 shows a detail of the user interface shown in Figure 2. The viewport 311 concerning exam cards is shown in more detail. Notably the representation 315 of the execution list shows the actual operational items, such as the acquisition sequences. Actually, in the situation shown in Figure 3, a survey scan and two T₁-weighted scans have been completed and a further T₁-weighted scan is in progress. From the representation 315 of the execution list is appears that a T₂-weighted sagittal scan, a T₁-weigher coronal scan and another T₂-weighted sagittal scan are to follow. Their indicator in the execution list show that for these operational items the geometric planning has been completed, or is available. Further scan property information is also shown: the first T₂-weighted sagittal scan involves table movement and the T₂-weighted sagittal scan involves a high SAR anticipated. Subsequent operational items involve contrast enhanced angio scans including preparation, a bolus track to determine the arrival of the contrast bolus at the *region of interest* and an actual contrast enhanced acquisition. These have a valid geometry planning. Finally, a T₂-weighted TSE sequence is envisaged, for which there is no geometry planning yet available.

In the info panel view port there is more detailed information made available to the operator concerning the active exam card. This information is for example made available by providing a hyperlink to relevant chapters of an electronic version of the application guide of the magnetic resonance imaging system.

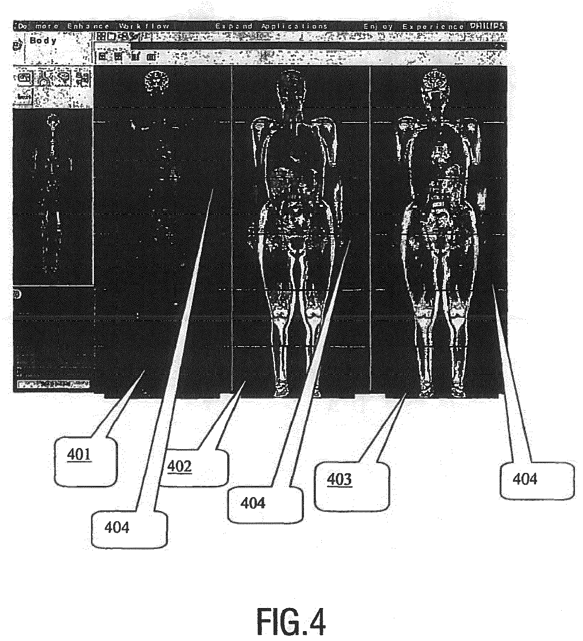

Figure 4 shows an example of a user interface of the diagnostic image modality of the invention in which several imaging sequences at individual imaging positions are carried out. Notably, Figure 4 shows that three viewports 401,402, 403 are employed in which different composite images are shown. Each of these composite images is built up from magnetic resonance images 404 (three being specifically indicated as reference numeral '404') that are acquired at respective stations. In the example of Figure 4 there are six stations employed namely at positions where images are acquired of the patient's head, shoulders, abdomen, upper legs, lower legs and feet, successively. For each station three image acquisitions are made so obtain magnetic resonance images of three different types of contrast. Attributed to these magnetic resonance images there is geometric information concerning the position at issue during acquisition of the image of the patient in the magnetic resonance imaging system. This geometric information is available on the basis of the geometry planning of the several image acquisitions at the various stations. On the basis of this geometric information the composite image are combined from the magnetic resonance images at successive stations, for example to form whole body images as shown in Figure 4.

## Claims

1. A diagnostic imaging system (1), in particular a magnetic resonance imaging system, comprising:
a control system (2) to control the execution of operational items by the diagnostic imaging system, the operational items having respective parameter settings and
a user interface (3) coupled to the control system, the user interface including
a scheduler module (4), which generates, in particular autonomously, for at least for part of the operational items an ordered selection of operational items on the basis of their respective parameter settings.

2. A diagnostic imaging system as claimed in Claim 1, wherein
- the control system controls the execution of operational items on the basis of an execution list and
the scheduler releases operational items according to the ordered selection.

3. A diagnostic imaging system as claimed in Claim 2, wherein the scheduler releases operational items in dependence of successful completion of preceding operational items of the ordered selection.

4. A magnetic resonance imaging system, as claimed in Claim 1, in which the operational items include image acquisition sequences and each image acquisition sequence having a geometry planning as an attribute, in particular several acquisitions sharing the same geometry planning, and
**characterized in that** the scheduler module (4) is configured to select acquisition sequences in the order of their geometry planning and initiates image acquisition sequences sharing the same geometry planning **in that** the scheduler releases image acquisition sequences sharing the same geometry planning to the execution list together once the geometry planning is carried out by the operator for at least one of the image acquisition sequences sharing the same geometry planning.

5. A diagnostic imaging system as claimed in Claim 1, wherein the scheduler module is provided with a memory, in particular a database with a browser, to store scan schedules.

6. A diagnostic imaging system as claimed in Claim 1, wherein the scheduler module is arranged to issue instructions to the user prompted by the operational items.

7. A diagnostic imaging system as claimed in Claim 1, wherein the scheduler module is arranged to make available to the user interface a description of the operational item, in particular in dependence of the operational item being released to the execution list.

8. A diagnostic imaging system as claimed in Claim 1, wherein the scheduler module is arranged to provide progress information to the user interface, said progress information being related to the way the execution of operational items is advancing.

9. A magnetic resonance imaging system, as claimed in Claim 1, and including a displaceable patient support wherein the control system is set up to
displace the patient support among various imaging positions and
conduct several imaging sequences at individual imaging positions and to
alternate performance of the several imaging sequences with the displacement of the patient support among the various imaging positions.
